**Europäisches Patentamt**

**European Patent Office**

**Office européen des brevets**

(11) Veröffentlichungsnummer : **0 218 737**
**B1**

(12)

# EUROPÄISCHE PATENTSCHRIFT

(45) Veröffentlichungstag der Patentschrift :
04.05.88

(21) Anmeldenummer : 85112897.5

(22) Anmeldetag : 11.10.85

(51) Int. Cl.⁴ : **G 01 P 3/48**, G 01 R 23/09,
H 03 H 17/00

(54) Einrichtung zur Ansteuerung eines Kreuzspulenanzeigeinstruments.

(43) Veröffentlichungstag der Anmeldung :
22.04.87 Patentblatt 87/17

(45) Bekanntmachung des Hinweises auf die Patenterteilung : 04.05.88 Patentblatt 88/18

(84) Benannte Vertragsstaaten :
FR GB IT NL SE

(56) Entgegenhaltungen :
DE-A- 3 003 151
US-A- 3 962 567
US-A- 4 051 434
US-A- 4 230 984
IEEE TRANSACTIONS ON POWER APPARATUS AND
SYSTEMS, Band. PAS 102, Nr. 8, August 1983, Seiten
2240-2246, New York US; J.L. DINELEY et al.: "Digital
rotor velocity and acceleration measurement for
generator control"

(73) Patentinhaber : **VDO Adolf Schindling AG**
**Gräfstrasse 103**
**D-6000 Frankfurt/Main (DE)**

(72) Erfinder : **Tibken, Martin, Dipl.-Ing.**
**Höhenstrasse 14**
**D-6231 Schwalbach (DE)**

(74) Vertreter : **Klein, Thomas, Dipl.-Ing. (FH)**
**Sodener Strasse 9 Postfach 6140**
**D-6231 Schwalbach a. Ts. (DE)**

EP 0 218 737 B1

0 218 737

**Beschreibung**

Die Erfindung betrifft eine Einrichtung zur Ansteuerung eines Kreuzspulanzeigeinstruments nach dem Oberbegriff des Anspruchs 1.

Kreuzspulinstrumente werden bevorzugt auch zur Anzeige nicht elektrischer Größen, wie beispielsweise der Geschwindigkeit eines Fahrzeugs eingesetzt, um die bekannten Vorteile dieses Instruments zu nutzen. Hierzu gehören eine kostengünstige Herstellung, eine hohe, über den Anzeigebereich weitgehend konstante Stellkraft und der große Anzeigebereich, der sich über vier Quadranten erstrecken kann. Zu den Nachteilen des Kreuzspulanzeigeinstruments gehört jedoch eine geringe Eigendämpfung, welche die Anzeige von Meßgrößen, die mit stark schwankenden Meßsignalen erfaßt werden, beeinträchtigt.

Insbesondere treten Schwierigkeiten auf, wenn die Drehzahl eines Otto-Motors mit einer Meßfrequenz gemessen werden soll, welche aus den Zündimpulsen abgeleitet ist. Dieses Meßsignal unterliegt kurzzeitigen kräftigen Schwankungen, die innerhalb einer Umdrehung des Otto-Motors auf Unwuchten und/oder die Zündverstellung zurückzuführen sein können.

Wenn wie in dem Falle der Drehzahlmessung auf der Grundlage der von den Zündimpulsen abgeleiteten Meßfrequenz ein elektronischer Umsetzer vorgesehen ist, der die Meßfrequenz in proportionale Meßzahlen umsetzt, sowie weiter eine Ansteuerlogikschaltung mit Treibern verwendet wird, die aus den Meßzahlen des Kreuzspulinstruments beaufschlagende Ströme bilden, gelangen die störenden Schwankungen des Meßsignals fast unvermindert zur Anzeige.

Der Umsetzer kann zur Bildung von Meßzahlen, die jeweils einer Meßfrequenz und damit der Drehzahl eines Otto-Motors proportional sind, aus einer Periodenmeßschaltung der Meßfrequenz und einem nachgeschalteten Dividierwerk bestehen. Die mit dem Dividierwerk gebildeten Meßzahlen werden in eine Ansteuerlogik eingespeist, welche für jede Meßzahl zwei in die üblichen beiden Spulen des Kreuzspulanzeigeinstruments einspeisbare Ströme erzeugt, die so groß sind, daß sich ein zu dem Meßsignal (hier Meßfrequenz) bzw. der Meßzahl proportionaler Zeigerausschlag einstellt.

Um aus einem Meßsignal das Kreuzspulinstrument beaufschlagende Ströme nach einer Funktion zu erzeugen, die einen dem Meßsignal proportionalen Zeigerausschlag über einen großen Winkel ergibt, ist eine Einrichtung bekannt, die gegebenenfalls auch eine Meßfrequenz verarbeiten kann (DE-OS 30 03 151). Diese Einrichtung umfaßt einen digitalen Frequenzmesser mit einem Tachoregister und einem Speicherregister, dem ein Inverter als Wandler nachgeschaltet ist. Speziell werden dem Wandler die unteren sieben Bits, die in dem Speicherregister gespeichert sind, von $2^0$ bis $2^6$ zugeführt. Der Wandler speist ein Signal in einen Funktionsgenerator zur Erzeugung des Ausgangssignals, das sich als eine Tangensfunktion des Signals in jeweils einem Bereich aus einer Vielzahl begrenzter Anzeigebereiche des Kreuzspulanzeigeinstruments ändert. Der Funktionsgenerator speist wiederum über einen Tastverhältnisgenerator eine Steuerlogikschaltung, die zwei Anzeigetreiber ansteuert. Dabei wird die Steuerlogikschaltung durch die oberen drei Bits des Speicherregisters angesteuert. Die Steuerlogikschaltung beeinflußt die Beaufschlagung der beiden Spulen des Kreuzspulenanzeigeinstruments und damit den Bereich, in dem dieses Instrument gerade arbeitet. Sie leitet den variablen Tastverhältnisstrom sinngemäß in eine der beiden Spulen und einen Konstantstrom in die andere der beiden Spulen.

Unabhängig davon, wie im einzelnen mit einem Umsetzer sowie mit einer Ansteuerlogikschaltung mit Treibern aus einer Meßfrequenz als Meßsignal die das Kreuzspulanzeigeinstrument beaufschlagenden Ströme erzeugt werden, bleibt der störende Einfluß von Meßfrequenzschwankungen voll erhalten, da mit den genannten Funktionsgruppen lediglich eine proportionale Beziehung zwischen dem Meßsignal und dem Zeigerausschlag angestrebt wird.

Die bekannten Einrichtungen zur Ansteuerung eines Kreuzspulanzeigeinstruments haben daher in der Praxis keine Verwendung zur Anzeige stark schwankender Meßsignale, insbesondere zur Anzeige einer Drehzahlgröße eines Otto-Motors gefunden.

Um Kreuzspulanzeigeinstrumente trotz deren geringer Eigendämpfung zur Anzeige von Meßgrößen verwendbar zu machen, die mit stark gestörten Meßsignalen wie der Meßfrequenz eines Otto-Motors erfaßt werden, bietet es sich zunächst an, die von den Treibern erzeugten Ströme, welche das Kreuzspulanzeigeinstrument beaufschlagen, mit Filtern zu glätten. Bei dieser Maßnahme ist aber nachteilig, daß für jeden Filter mindestens ein verhältnismäßig aufwendiger Kondensator des Bipolartyps einzusetzen ist. Dieser Lösung sind auch die Baugrößen des Kondensators bzw. des Filters abträglich. Die voranstehenden Nachteile gelten um so mehr, als sich der Aufwand und der Raumbedarf für die Glättungsmittel der beiden Ströme, die in ein Kreuzspulanzeigeinstrument eingespeist werden, verdoppeln kann. Hinzu kommt eine Verringerung der Genauigkeit, die infolge Alterung des Kondensators oder der Kondensatoren eintreten kann.

Der vorliegenden Erfindung liegt daher die Aufgabe zugrunde, eine Einrichtung zur Ansteuerung eines Kreuzspulanzeigeinstruments in Abhängigkeit von einem Meßsignal in der Weise weiterzubilden, daß auch durch stark gestörte bzw. schwankende Meßsignale repräsentierte Meßgrößen gut ablesbar, d. h. ruhig und exakt angezeigt werden.

Diese Aufgabe wird durch die Einrichtung mit den in Anspruch 1 angegebenen Merkmalen gelöst.

Das Wesen der Erfindung besteht darin, daß die störenden Schwankungen des Meßsignals beseitigt werden, nachdem dieses durch den Umsetzer in proportionale Meßzahlen umgesetzt ist, und bevor die

2

Ansteuerlogik mit den Meßzahlen beaufschlagt wird. Somit werden durch die Ansteuerlogikschaltung mit Treibern bereits geglättete, das Kreuzspulanzeigeinstrument beaufschlagende Ströme generiert. Durch das vorgesehene digitale Verzögerungsglied zweiter Ordnung ($PT_2$-Glied) können störende Schwankungen der Meßzahlen kurzfristig weitgehend eliminiert werden, und zwar ohne eine unerwünscht große Verzögerung zwischen der Änderung der Meßgröße und dem sie darstellenden Ausschlag des Kreuzspulanzeigeinstruments hervorzurufen. Die Genauigkeit der gesamten Einrichtung zur Ansteuerung des Kreuzspulanzeigeinstruments bleibt praktisch vollständig erhalten, da bei der digitalen Verarbeitung der Meßzahlen zur Bildung einer Verzögerung zweiter Ordnung die bei einer Integerteilung der Meßzahlen entstehenden Restwerte mit Restwertspeichern erfaßt und in die Verarbeitung der Meßzahlen einbezogen werden. Dabei wird davon ausgegangen, daß die Meßzahl in jedem Fall eine ganze Zahl ($2^0$ oder eine höhere Potenz von 2), also eine Integerzahl ist, die mit dem Umsetzer erzeugt wird und die die Ansteuerlogikschaltung verarbeiten soll. Infolge der digitalen Bildung der Verzögerung zweiter Ordnung ist ein hoher Aufwand für Glättungsmittel der das Kreuzspulanzeigeinstrument speisenden Ströme oder konstruktive Dämpfungsmaßnahmen des Kreuzspulanzeigeinstruments selbst vermieden, wobei letztere ein unerwünscht träges aperiodisches Anzeigeverhalten hervorrufen können.

Besonders geschickte Realisierungen des digitalen Verzögerungsglieds zweiter Ordnung ($PT_2$-Glied) sind in den Unteransprüchen angegeben. Durch diese Ausbildungen wird der schaltungstechnische Aufwand weiter begrenzt.

Die Erfindung wird im folgenden anhand einer Zeichnung mit drei Figuren näher erläutert. Es zeigen :

Fig. 1 ein Blockschaltbild der gesamten Einrichtung zur Ansteuerung eines Kreuzspulanzeigeinstruments in Abhängigkeit von einer Meßfrequenz,

Fig. 2 ein Blockschaltbild eines digitalen Verzögerungsglieds erster Ordnung ($PT_1$-Glied), und

Fig. 3 ein Blockschaltbild eines digitalen Verzögerungsglieds zweiter Ordnung ($PT_2$-Glied), welches die Dämpfungsmittel in Fig. 1 darstellt.

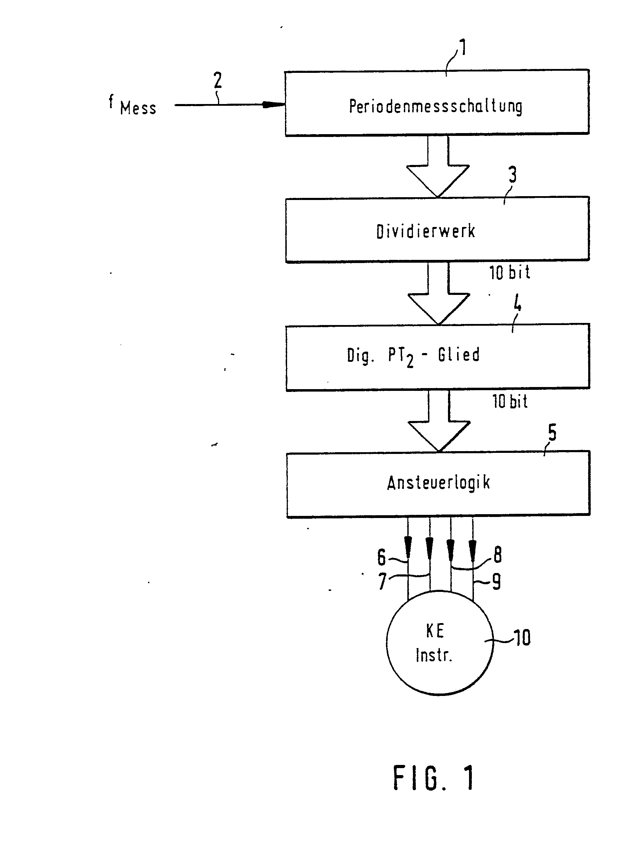

In Fig. 1 ist mit 1 eine Schaltungsanordnung zur Periodendauermessung bezeichnet, die mit einer Meßfrequenz $f_{Mess}$ an Eingang 2 gespeist wird. In der Schaltungsanordnung 1 wird eine periodisch abgetastete Meßfrequenz beispielsweise durch Auszählen der Periodendauer mit einer festen Taktfrequenz in eine der Meßfrequenz reziproke Zahl umgewandelt. Um aus diesen Zahlen Meßzahlen zu bilden, die der Meßfrequenz wieder proportional sind, werden sie in ein Dividierwerk 3 eingespeist.

Somit bilden die Schaltungsanordnung 1 zur Periodendauermessung und das Dividierwerk 3 den Umsetzer, der die Meßfrequenz in proportionale Meßzahlen umsetzt. Die Meßzahlen werden mit Dualzahlen, deren kleinste Zahl $2^0$ ist, als Integerzahlen dargestellt.

Diese Meßzahlen werden in ein digitales Verzögerungsglied zweiter Ordnung ($PT_2$-Glied) 4 eingespeist. Hierin werden unerwünschte kurzfristige Störungen des Meßsignals ausgefiltert. Bei der Dimensionierung des digitalen Verzögerungsglieds zweiter Ordnung wird davon ausgegangen, daß die Störungen eine höhere Frequenz als die Änderungen der Meßgröße haben. Durch das digitale $PT_2$-Glied wird eine relativ steile Filtercharakteristik bei großer Unempfindlichkeit gegen Störungen erzielt.

Die in dieser Weise korrigierten Meßzahlen werden in eine Ansteuerlogik 5 eingespeist, welche in üblicher Weise aus den Meßzahlenwerten zwei Ströme erzeugt, die über Leitungen 6 bis 9 in zwei nicht dargestellte Spulen eines Kreuzspulanzeigeinstruments 10 eingespeist werden.

Der mit dem Kreuzspulanzeigeinstrument 10 angezeigte Wert ist damit im eingeschobenen Zustand proportional der Meßfrequenz an Eingang 2, wobei jedoch störende Schwankungen der Meßfrequenz, und zwar auch geringe Schwankungen der Meßfrequenz nicht angezeigt werden. Die Anzeige ist also exakt, ruhig und genau ablesbar.

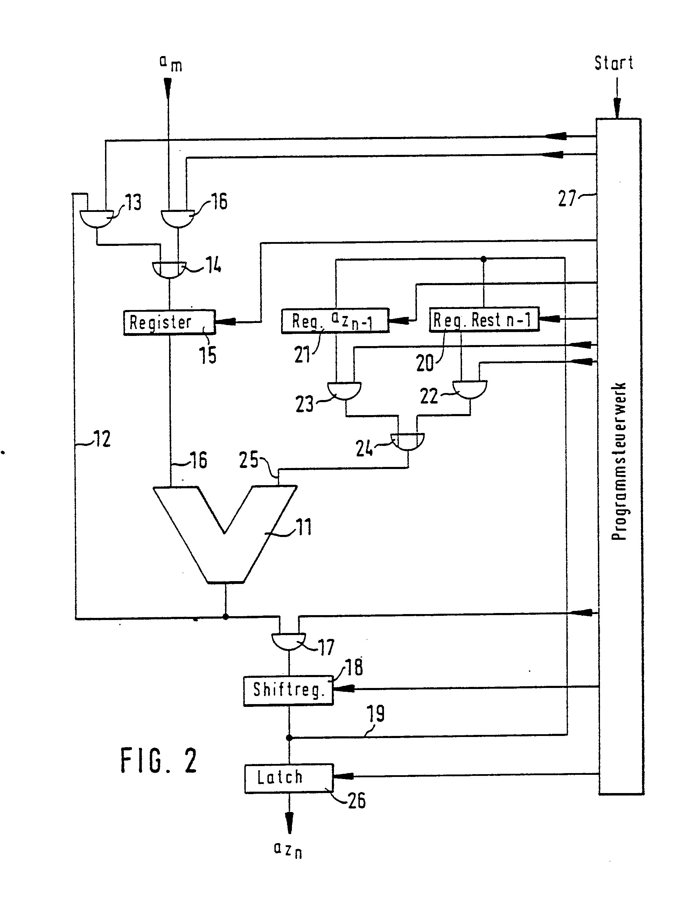

Zu diesem Zweck wird im einzelnen ein digitales Verzögerungsglied zweiter Ordnung ($PT_2$-Glied), vorgesehen, welches im wesentlichen aus zwei hintereinandergeschalteten Verzögerungsgliedern erster Ordnung ($PT_1$-Glieder) mit Restwerteverarbeitung aufgebaut ist. Ein solches $PT_1$-Glied mit Restwerteverarbeitung ist in Fig. 2 dargestellt :

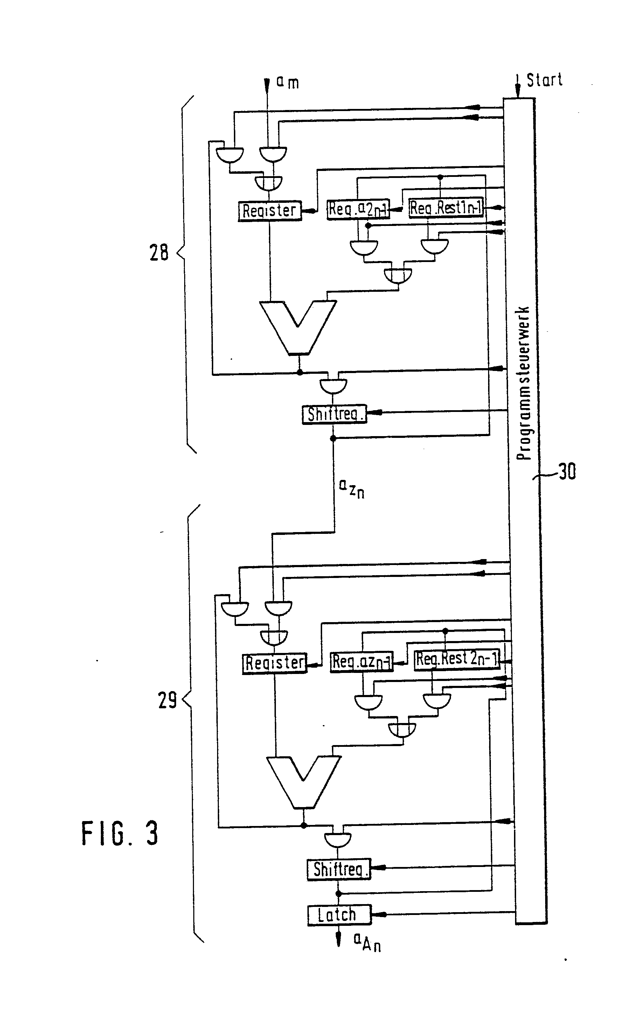

In Fig. 2 ist ein digitales Verzögerungsglied erster Ordnung als eine Stufe des zweistufigen digitalen Verzögerungsglieds zweiter Ordnung, siehe Fig. 3, dargestellt.

Das digitale Verzögerungsglied erster Ordnung umfaßt einen Addierer 11 zum mehrfachen Addieren über eine Schleife 12, die über ein UND-Glied 13 und ein ODER-Glied 14 zu einem Register 15 führt. Das Register ist ausgangsseitig an einen ersten Eingang 16 des Addierers angeschlossen. In das Register 15 ist außerdem über ein UND-Glied 16 und das ODER-Glied 14 ein binärer Meßwert $a_m$ einspeisbar.

Ausgangsseitig steht der Addierer 11 über ein weiteres UND-Glied 17 mit einem Schieberegister 18 in Verbindung. Von dem Ausgang des Schieberegisters führt eine Leitung 19 zu einem Restwertregister 20 sowie einem Altwertregister 21. Jedes der beiden Register ist ausgangsseitig über je ein UND-Glied 22 bzw. 23 und ein gemeinsames ODER-Glied 24 an einen zweiten Eingang 25 des Addierers angekoppelt.

Von dem Ausgang des Schieberegisters 18 führt eine weitere Verbindung über einen Zwischenspeicher 26 zu einem Ausgang $a_{zn}$, der einen Zwischenwert der Dämpfung abgibt.

Das beschriebene digitale Verzögerungsglied erster Ordnung wird durch ein Programmsteuerwerk 27 in selbsttätig aufeinanderfolgenden Durchläufen gesteuert, wobei während jedes Durchlaufes eine Mehrfach-Addition und zum Abschluß des Durchlaufes eine Division in dem Schieberegister durchgeführt werden. Hierzu wirkt das Programmsteuerwerk insbesondere auf die UND-Glieder 13, 16, 17 sowie auf

3

sämtliche Register ein.

Damit errechnet das digitale Verzögerungsglied erster Ordnung einenZwischenwert der Dämpfung $a_{zn}$ bzw. einen Restwert $R_1$ entsprechend der folgenden Beziehung aus dem Meßwert $a_{m}$, dem Zwischenwert der Dämpfung, der während des vorangehenden Durchlaufs errechnet wurde $a_{zn-1}$, dem Restwert, der während des vorangehenden Durchlaufs errechnet wurde $R_{1n-1}$ und einer Dämpfungskonstanten d :

$$a_{z_n} ; R_{1_n} = \frac{a_{z_{n-1}} \cdot (d-1) + R_{1_{n-1}} + a_m}{d}$$

Aus die Einzelvorgänge wird noch weiter unten eingegangen.

Zunächst wird zu Fig. 3 bemerkt, daß das hierin dargestellte digitale Verzögerungsglied zweiter Ordnung aus zwei hintereinandergeschalteten Stufen des Verzögerungsglieds erster Ordnung nach Fig. 2 besteht. Die erste Stufe ist in Fig. 3 mit 28 bezeichnet, und die zweite Stufe trägt das Bezugszeichen 29. Das zugehörige Programmsteuerwerk 30 ist ähnlich wie das Programmsteuerwerk 27 für eine Stufe aufgebaut. Der Ausgang der ersten Stufe für den Zwischenwert der Dämpfung $a_{zn}$ bildet zugleich den Eingang der zweiten Stufe. Am Ausgang der zweiten Stufe erscheint der Anzeigewert $a_{An}$. Dieser Anzeigewert wird der Ansteuerlogik 5 in Fig. 1 zugeführt.

Die in Fig. 3 dargestellte zweite Stufe 29 bildet in grundsätzlich gleicher Weise wie die erste Stufe folgende Beziehung, in der zusätzlich zu den erläuterten Größen $R_{2n-1}$ der Restwert der zweiten Stufe ist und $a_{An-1}$ der Anzeigewert, der während eines vorangehenden Durchlaufes n - 1 errechnet wurde :

$$a_{A_n} ; R_{2_n} = \frac{a_{A_{n-1}} \cdot (d-1) + R_{2_{n-1}} + a_{z_n}}{d}$$

Für eine angenommene Dämpfung d = 4 errechnen sich damit für binäre 2-Bit-Worte (tatsächlich werden 10-Bit-Worte verwendet) folgende Werte in dem zweistufigen digitalen Verzögerungsglied zweiter Ordnung :

| n | $a_m$ | $a_{z_{n-1}}$ | $R_1$ | $a_{z_n}$ | $a_{A_{n-1}}$ | $R_2$ | $a_{A_n}$ |
|---|---|---|---|---|---|---|---|
| -1 | □□ | □□ | □□ | □□ | □□ | □□ | □□ |
| 0 | 01 | 00 | 01 | 00 | 00 | 00 | 00 |
| 1 | 01 | 00 | 10 | 00 | 00 | 00 | 00 |
| 2 | 01 | 00 | 11 | 00 | 00 | 00 | 00 |
| 3 | 01 | 00 | 00 | 01 | 00 | 01 | 00 |
| 4 | 01 | 01 | 00 | 01 | 00 | 10 | 00 |
| 5 | 01 | 01 | 00 | 01 | 00 | 11 | 00 |
| 6 | 01 | 01 | 00 | 01 | 00 | 00 | 01 |
| 7 | 01 | 01 | 00 | 01 | 01 | 00 | 01 |

In der Tabelle enthält die linke Kolonne n eine Ordnungsnummer des jeweiligen Durchlaufs, in der rechts daran anschließenden Kolonne den Meßwert $a_n$, der während der acht Durchläufe konstant ist, in den daran nach rechts anschließenden drei Kolonnen die in der ersten Stufe gebildeten Werte und in den letzten drei Kolonnen die in der zweiten Stufe errechneten Werte.

Zur Arbeitsweise der ersten Stufe wird zunächst angenommen, daß das Programmsteuerwerk bei einem Durchlauf n = 0 gestartet wird. Zu diesem Zeitpunkt war bereits in das Altwertregister 21 der Wert 0 eingespeichert, das Restwertregister 20 enthält den Wert. 00. (Es wird an dieser Stelle bemerkt, daß die Restwerte $R_1$ und $R_2$ Nachkommastellen beinhalten.) In dem Register 15 ist zu diesem Zeitpunkt der Meßwert $a_m$ = 01 eingespeichert. Der Addierer errechnet dann zunächst die Summe $a_m + a_{zn-1}$ und addiert mehrfach zu diesem erreichten Wert den Altwert $a_{zn-1}$, bis das Produkt $a_{zn-1} \cdot 3$ erreicht ist. Der in der vorangehenden Umlaufzeit erreichte Restwert $R_{n-1}$ wird gleichzeitig mitaddiert, die Reste können aber in anderer Ausführungsform auch gesondert addiert werden. In jedem Fall erscheint in dem Schieberegister 18 nach der geschilderten Mehrfachaddition der Wert $a_{zn-1} \cdot 3 + R_{1n-1} + a_m$, der durch Verschieben nach rechts noch durch d = 4 zu teilen ist, d. h. der Wert in dem Schieberegister wird zweimal nach rechts geschoben. Damit erscheint am Ende des 0. Durchlaufs der Zwischenwert der Dämpfung $a_{zn}$ = 00 und der Restwert $R_1$ = 01. Die zweite mit diesen Werten gespeiste Stufe 29 errechnet daraus den Anzeigewert $a_{An}$ = 00 und den Restwert der zweiten Stufe $R_2$ = 00, wobei der Anzeigewert

4

des vorangehenden Durchlaufs $a_{An-1}$ ebenfalls = 00 ist. Für den nächsten Durchlauf n = 1 wird jetzt $a_{zn-1}$ = 00 und der Restwert der ersten Stufe gleich 10. Diese Vorgänge wiederholen sich sinngemäß, bis nach dem vierten Durchlauf (n = 3) der Zwischenwert der Dämpfung $a_{zn}$ = 01 den Meßwert $a_m$ erreicht. Dabei errechnet jedoch die zweite Stufe erst den Restwert $R_2$ = 01. Erst bei n = 6, also nach dem siebten Durchlauf, nimmt der Anzeigewert $a_{An}$ = 01 den Betrag des Meßwerts an.

Wichtig ist, daß nur in dem Fall, in dem Störungsimpulse während dieser Durchläufe auftraten, der Anzeigewert in gleicher Weise verändert wird, während bei kürzeren Störimpulsen deren Einfluß ausgemittelt wird. Vorteilhaft ist dabei, daß, nachdem am Ausgang der zweiten Stufe der Anzeigewert erst einmal ansteht, dieser fortlaufend in der richtigen Richtung entsprechend dem Meßwert verändert wird, also ein annähernd stetiger Einlauf der Zeigerstellung des Kreuzspulanzeigeinstruments erfolgt.

**Patentansprüche**

1. Einrichtung zur Ansteuerung eines Kreuzspulanzeigeinstruments in Abhängigkeit von einem Meßsignal, insbesondere einer Meßfrequenz, mit einem Umsetzer, der das Meßsignal in proportionale Meßzahlen als Integerzahlen umsetzt, sowie mit einer Ansteuerlogik-Schaltung mit Treibern, die aus den Meßzahlen das Kreuzspulanzeigeinstrument beaufschlagende Ströme erzeugen, dadurch gekennzeichnet, daß in Signalflußrichtung zwischen dem Umsetzer (1, 3) und der Ansteuerlogik-Schaltung (5) ein digitales Verzögerungsglied 2. Ordnung (4) sorgenanntes $PT_2$; Glied vorgesehen ist, das Mittel (20, 22) zur Restwertverarbeitung der bei einer Integerteilung der Meßzahlen entstehenden Restwerte einschließlich Restwertspeichern (20) umfaßt.

2. Einrichtung nach Anspruch 1, dadurch gekennzeichnet, daß das digitale Verzögerungsglied 2. Ordnung (4) im wesentlichen aus zwei untereinandergeschalteten digitalen Verzögerungsgliedern 1. Ordnung ($PT_1$-Glieder 28, 29) mit je einem zugeordneten Restwertspeicher besteht.

3. Einrichtung nach Anspruch 1 oder 2, dadurch gekennzeichnet, daß jedes der beiden digitalen Verzögerungsglieder 1. Ordnung (28, 29) einen Addierer (11) zum mehrfachen Addieren, ein mit einem ersten Eingang (16) des Addierers verbundenes Register (15) für den binären Meßwert ($a_m$) bzw. einen in einem vorgeschalteten digitalen Verzögerungsglied 1. Ordnung errechneten Zwischenwert ($a_{zn}$) der Dämpfung, ein mit einem Ausgang des Addierers in Verbindung stehendes Schieberegister (18), in das ein von dem Addierer addierter binärer Wert einspeisbar ist, in dem der eingespeiste binäre Wert zur Druchführung einer Division verschiebbar ist und aus dem der verschobene binäre Wert über ein Altwertregister (21) und ein Restwertregister (20) in einen zweiten Eingang (25) des Addierers zurückübertragbar ist, umfaßt und daß diese Komponenten durch ein Programmsteuerwerk (27 bzw. 30) zum mehrfachen Addieren und anschließendem Verschieben in jedem von selbsttätig aufeinanderfolgenden Durchläufen steuerbar sind.

4. Einrichtung nach den Ansprüchen 1 - 3, dadurch gekennzeichnet, daß das Verzögerungsglied 2. Ordnung (28, 29) und die Mittel zur Restwertverarbeitung durch einen I C-Baustein realisiert sind, der auch den Umsetzer (1, 3) und die Ansteuer-Logik (5) umfaßt.

**Claims**

1. Device for driving a cross-coil instrument in dependence on a measurement signal, in particular a measurement frequency, comprising a converter which converts the measurement signal into proportional measurement numbers as integer numbers, and a drive logic circuit with drivers which generate currents applied to the cross-coil instrument from the measurement numbers, characterized in that a second-order digital delay section (4), a so-called $PT_2$ section, which comprises means (20, 22) for processing the residual values produced during an integer division of the measurement numbers, including residual value memories (20), is provided between the converter (1, 3) and the drive logic circuit (5) in the signal flow direction.

2. Device according to Claim 1, characterized in that the second-order digital delay section (4) essentially consists of two stacked first-order digital delay sections ($PT_1$ sections 28, 29) each having an associated residual value memory.

3. Device according to Claim 1 or 2, characterized in that each of the two first-order digital delay sections (28, 29) comprises an adder (11) for multiple adding, a register (15) which is connected to a first input (16) of the adder, for the binary measurement value ($a_m$) or an intermediate value ($a_{zn}$) of the attenuation, calculated in a preceding first-order digital delay section, a shift register (18) which is connected to an output of the adder and into which a binary value added by the adder can be fed, in which the fed-in binary value can be shifted for carrying out a dividing operation and from which the shifted binary value can be transferred back into a second input (25) of the adder via an old-value register (21) and a residual-value register (20), and that these components can be controlled by a programmed control unit (27 and 30) for multiple adding and subsequent shifting in each run of runs automatically following one another.

4. Device according to Claims 1 - 3, characterized in that the second-order delay section (28, 29) and the means for residual value processing are implemented by an IC chip which also comprises the converter (1, 3) and the drive logic (5).

**Revendications**

1. Dispositif destiné au pilotage d'un instrument d'affichage à cadres croisés en fonction d'un signal de mesure, en particulier d'une fréquence de mesure, comportant un convertisseur, qui convertit le signal de mesure en nombres représentatifs de la mesure proportionnels sous forme de nombres entiers, ainsi qu'un circuit logique de pilotage comportant des amplificateurs qui créent à partir des nombres représentatifs de la mesure les courants auxquels est soumis l'instrument d'affichage à cadres croisés, caractérisé par le fait que dans le sens de progression du signal on prévoit entre le convertisseur (1, 3) et le circuit logique (5) de pilotage un organe de retardement numérique de deuxième ordre (4), dit organe PT$_2$, qui comporte des moyens (20, 22) destinés au traitement des valeurs de restes résultant d'une division à quotient entier des nombres représentatifs de la mesure, y compris des mémoires (20) destinées aux restes.

2. Dispositif selon la revendication 1, caractérisé par le fait que l'organe de retardement numérique de deuxième ordre (4) se compose essentiellement de deux organes de retardement numérique de premier ordre (organes PT$_1$, 28, 29) comportant chacun une mémoire de valeurs de restes qui lui est affectée.

3. Dispositif selon l'une des revendications 1 ou 2, caractérisé par le fait que chacun des deux organes de retardement de premier ordre (28, 29) comprend un totalisateur (11) destiné à des additions multiples, un registre (15) relié à la première entrée (16) du totalisateur, pour la valeur de mesure binaire (a$_m$), respectivement une valeur moyenne (a$_{zn}$) d'amortissement calculée dans un organe digital de retardement de premier ordre branché en amont, un registre à décalage (18) relié à une sortie du totalisateur ; dans lequel peut être stockée une valeur binaire additionnée par le totalisateur, et dans lequel la valeur binaire, stockée peut être décalée pour l'exécution d'une division et duquel la valeur binaire décalée peut être transmise, par un registre (21) de valeurs anciennes et un registre (20) de valeurs de restes, à une deuxième entrée (25) du totalisateur, et que ces composants peuvent être pilotés grâce à un dispositif (27, 30) de pilotage de programme, en vue d'additions multiples et du décalage qui suit au cours de chacune des séquences qui se déroulent automatiquement les unes derrière les autres.

4. Dispositif selon l'une quelconque des revendications 1 à 3, caractérisé par le fait que l'organe de retardement de deuxième ordre (28, 29) et les moyens de traitement des valeurs de reste sont réalisés au moyen d'un circuit intégré qui comprend également le convertisseur (1, 3) et la logique de pilotage (5).

FIG. 1

FIG. 2

FIG. 3